# FASCICULE DE BREVET EUROPEEN

(11) **EP 4 017 832 B1**
(45) Date de publication et mention de la délivrance du brevet: **22.07.2026**
(21) Numéro de dépôt: 20775692.5
(22) Date de dépôt: 18.08.2020
(51) Int. Cl.: B81B 7/04, B81C 1/00

(54) **PROCÉDÉ DE SCELLEMENT DE CAVITÉS PAR DES MEMBRANES**
VERFAHREN ZUR ABDICHTUNG VON HOHLRÄUMEN MITTELS MEMBRANEN
METHOD FOR SEALING CAVITIES USING MEMBRANES

(30) Priorité: 21.08.2019 FR 1909318
(43) Date de publication de la demande: 29.06.2022
(73) Titulaire: Commissariat à l'Energie Atomique et aux Energies Alternatives, 75015 Paris (FR); SOITEC, 38190 Bernin (FR)
(72) Inventeur: SALVETAT, Thierry, 38054 Grenoble Cedex 09 (FR); GHYSELEN, Bruno, 38170 Seyssinet-Pariset (FR); BENAISSA, Lamine, 38054 Grenoble Cedex 09 (FR); COUTIER, Caroline, 38054 Grenoble Cedex 09 (FR); GAUDIN, Gweltaz, 38920 Crolles (FR)
(74) Mandataire: Santarelli
(86) Numéro de dépôt international: PCT/FR2020/051476
(87) Numéro de publication internationale: WO 2021/032927

(56) Documents cités:
- US-A1- 2013 302 934

## Description

### DOMAINE TECHNIQUE

La présente invention se rapporte au domaine des substrats et/ou des micros systèmes électromécaniques, notamment pour la détection des gaz ou plus généralement la réalisation de dispositifs transducteurs à base de membrane et notamment les transducteurs ultrasoniques.

En particulier, la présente invention concerne un procédé de fabrication, de manière collective, d'une pluralité de membranes scellant des cavités.

Le procédé selon la présente invention comprend la formation d'un premier contour, comprenant notamment une première tranchée, avantageusement continue, formé autour d'un agencement de cavités destinées à être scellées par des membranes. Le contour est notamment mis en œuvre pour amortir ou concentrer la déformation susceptible d'être imposée aux membranes lors de leur formation.

### ÉTAT DE LA TECHNIQUE ANTÉRIEURE

La mise en œuvre de membranes suspendues présente un intérêt grandissant tant dans le domaine des micros systèmes électromécaniques (« MEMS » ou « Mechanical Electromechanical Micro Systems » selon la terminologie Anglo-Saxonne) que celui des substrats et notamment des substrats temporaires.

Ces membranes, formées par un film de scellement, scellent avantageusement des cavités, notamment des cavités réalisées en surface dans un substrat support.

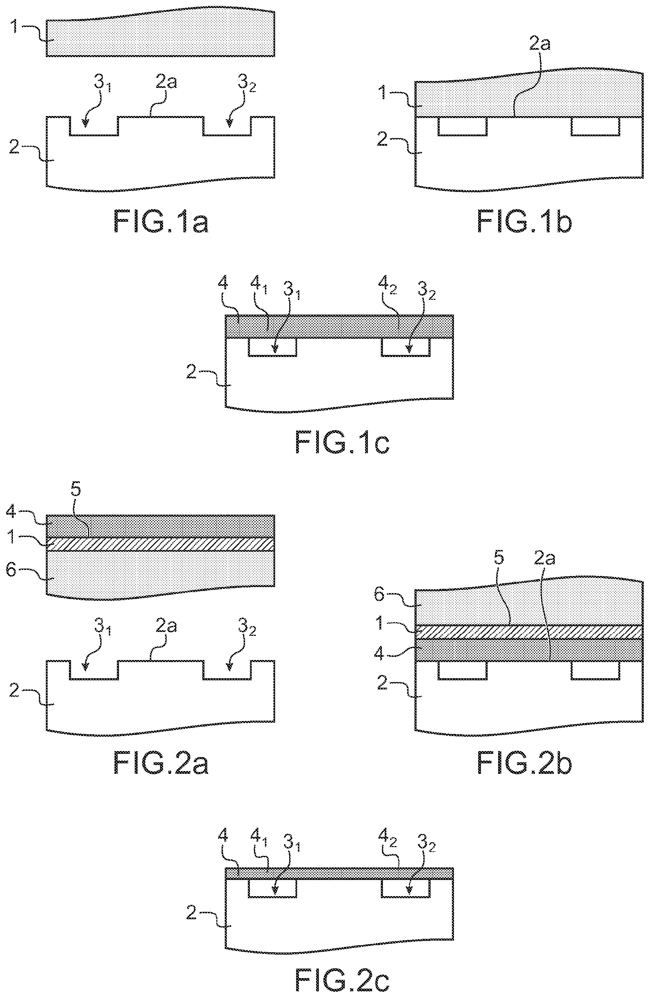

Un procédé connu de l'état de la technique pour la formation de membranes scellant des cavités est illustré aux figures 1a à 1c.

Ce procédé comprend notamment les étapes suivantes :
i) une étape de fourniture d'un substrat donneur 1 et d'un substrat receveur 2 pourvu de cavités 3₁, 3₂ débouchant au niveau d'une face avant 2a dudit substrat receveur 2 ;
ii) une étape d'assemblage du substrat donneur 1 et du substrat receveur 2 de manière à sceller les cavités 3 ;
iii) une étape d'amincissement du substrat donneur 1 de manière à ne conserver qu'une partie dudit substrat 1, dite film de scellement 4, et formant l'ensemble des membranes 4₁, 4₂...

L'étape iii) d'amincissement, généralement exécutée au moyen d'une gravure mécanique (« Grinding » selon la terminologie Anglo-Saxonne) et/ou chimique, consomme de manière définitive le substrat donneur.

Par ailleurs, l'uniformité du film de scellement à l'issue de l'étape iii), très dépendante de la technique employée lors de l'étape iii), reste difficilement contrôlable.

En outre, les sections de film de scellement à l'aplomb des cavités ne subissent aucune contre-pression de la part de ces dernières. L'obtention de membranes très fines, par exemple d'une épaisseur inférieure à 5 µm, n'est donc pas envisageable sans risquer de casser des membranes dès lors que l'étape iii) comprend un amincissement mécanique.

Afin de pallier les problématiques liées à l'uniformité et à l'obtention de membranes fines, le substrat donneur peut être démontable (tel qu'illustré à la figure 2a).

Un tel substrat donneur 1 comprend notamment une couche, dite couche d'arrêt 5 s'interposant entre un support mécanique 6 et le film de scellement 4 destiné à former les membranes 4₁, 4₂ à l'issue de l'étape iii).

La couche d'arrêt 5 peut, en particulier, être gravée de manière sélective par rapport au film de scellement, de sorte que l'uniformité d'épaisseur des membranes n'est que peu ou pas affectée par l'étape d'amincissement (figure 2c).

À titre d'exemple, dès lors que les membranes comprennent du silicium, le substrat donneur démontable peut être un substrat du type silicium sur isolant (« SOI »).

Toutefois, un tel substrat, dont le « démontage » conduit également à la consommation du support mécanique et de la couche d'arrêt, présente un coût qui n'est pas compatible avec les requis des industries microélectroniques et/ou micro mécaniques.

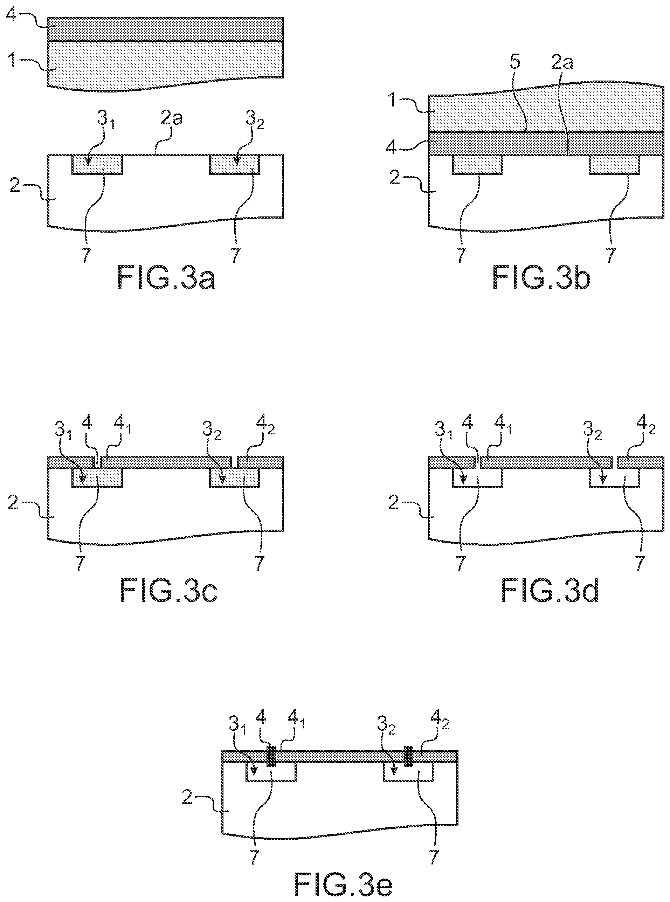

De manière alternative ou complémentaire, les cavités formées lors de l'étape i) (figure 3a) peuvent être remplies d'un matériau sacrificiel 7 destiné à être retiré à l'issue de l'étape iii) lors d'une étape iv) (figures 3c et 3d). Cependant, cette dernière étape requiert la formation d'une ouverture dans chacune des membranes, et leur colmatage après retrait du matériau sacrificiel (figure 3e). Cette dernière approche reste donc complexe et est susceptible d'engendrer des modifications de comportement mécanique des membranes.

L'approche dite « Smart-Cut^{™} », décrite dans le document EP533551, peut également être considérée.

Cette approche permet de transférer un film de scellement en détachant ce dernier d'un substrat, dit substrat donneur, au niveau d'une zone de fracture. La zone de fracture formée par implantation et/ou amorphisation permet de délimiter un film de scellement relativement fin (notamment d'une épaisseur inférieure à 2 µm, par exemple 1,5 µm). Par ailleurs, l'approche « Smart-Cut^{™} » ouvre la voie à la réutilisation du substrat donneur pour transférer à nouveau un film de scellement.

Les membranes formées par le film de scellement présentent une déformation qui n'est pas uniforme d'une membrane à l'autre dès lors que ces dernières sont formées sur un agencement, et notamment un agencement matriciel, de cavités.

Plus particulièrement, la déformation augmente du centre vers le bord de l'agencement de membranes.

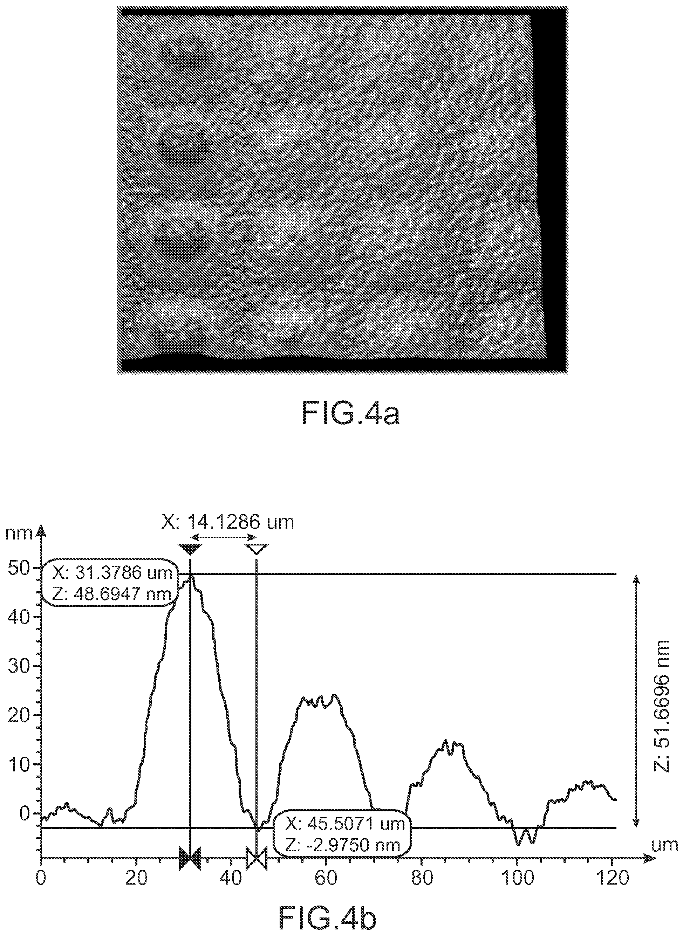

À cet égard, la figure 4a et la figure 4b illustrent, respectivement, une image obtenue par interférométrie optique, et un profil de déformation de membranes formées par le procédé Smart-Cut^{™} et selon un agencement matriciel.

Ces deux figures révèlent très clairement une non uniformité de déformation d'une membrane à l'autre.

Ces déformations des membranes sont par ailleurs d'autant plus importantes que le film de scellement est fin.

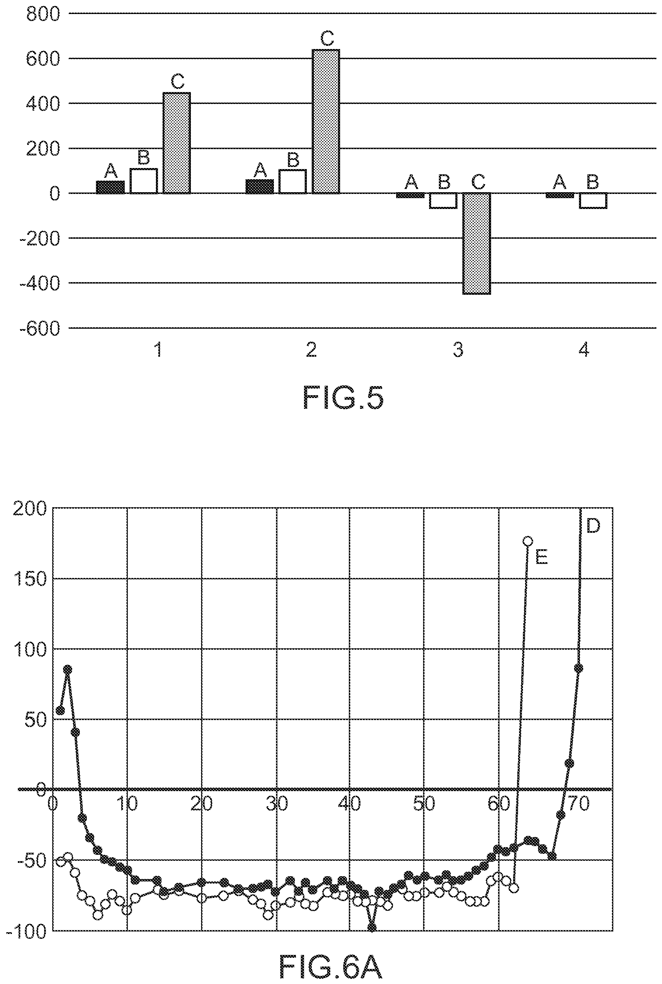

La figure 5 est une représentation graphique de cet effet. Notamment, la figure 5 illustre, en fonction des conditions de collage ( conditions « 1 », « 2 », « 3 », et « 4 » selon l'axe horizontal) l'amplitude (selon l'axe vertical, en « nm ») observée des déformations des membranes pour des épaisseurs de film de scellement de 1,5 µm (A), de 0,85 µm (B), et de 0,2 µm (C).

Cette variabilité est également fonction de l'environnement, notamment l'environnement proche, de la membrane. Plus celle-ci est éloignée d'autres membranes et plus la déformation est importante.

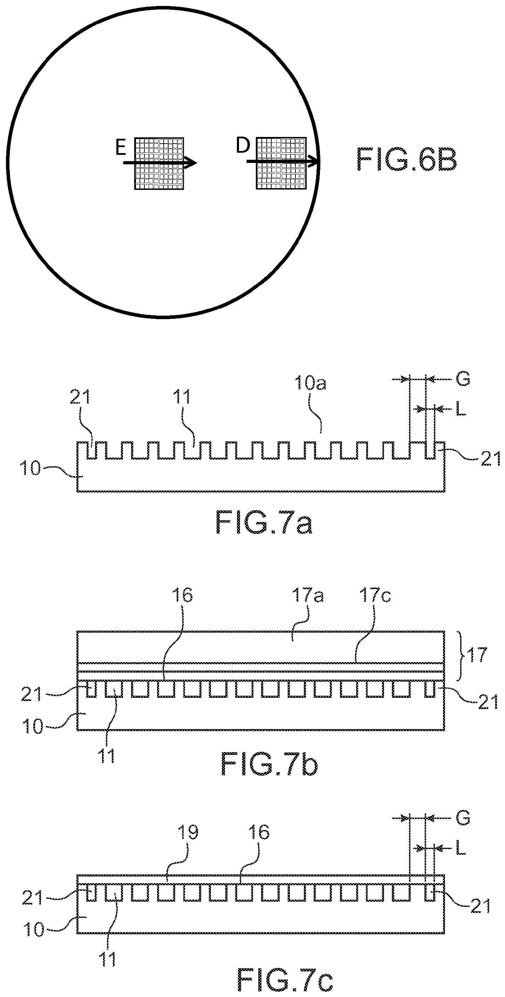

Enfin cette variabilité est également fonction de la localisation de la matrice de cavités sur le substrat receveur 2. La figure 6A est une représentation graphique des déformations des membranes d'une matrice au centre et d'une matrice au bord d'un substrat (figure 6b). Notamment, une variabilité des déformations plus importante peut être observée pour une matrice localisée à proximité du bord du substrat receveur (figure 6A, courbe D) par rapport à une matrice identique localisé à proximité du centre dudit substrat (figure 6A, courbe E).

La variabilité de ces déformations génère des comportements électromécaniques variables des membranes dans les dispositifs de type MEMS ou NEMS par exemple.

Elle peut également rendre la réalisation d'étapes technologiques ultérieures beaucoup plus inhomogènes, complexes voire impossibles.

Le document US 2013/302934 A1 divulgue un procédé de scellement d'une pluralité des cavités sur un substrat grâce au dépôt d'un film de scellement, les cavités sont circonscrite par un contour comprenant une tranchée, le film de scellement recouvre également entièrement la tranchée circonférentielle. Le rapport entre les diamètres des cavités et la distance entre les cavités et la tranchée est ajusté afin de réduire l'hétérogénéité de la déformation des membranes au niveau des cavités.

Un but de la présente invention est de proposer un procédé de scellement d'une pluralité de cavités par des membranes permettant de réduire le différentiel de déformation entre ces dernières.

### EXPOSÉ DE L'INVENTION

Le but de l'invention est atteint par un procédé de scellement d'une pluralité de cavités par une pluralité de membranes, le procédé comprenant les étapes suivantes :
a) une étape de formation d'une pluralité de cavités débouchant au niveau d'une face avant d'un substrat support ou au niveau d'une face de scellement d'un film de scellement, les cavités, avantageusement agencées de manière matricielle, présentent une profondeur p, une dimension caractéristique a, qui est la plus grande dimension de cavité, et sont espacées d'un espacement b ;
b) une étape de formation d'une pluralité de membranes, scellant chacune des cavités, par report du film de scellement en recouvrement de la face avant le report comprenant l'assemblage de la face de scellement avec la face avant ; le procédé étant caractérisé en ce qu'il comprend une étape a1), exécutée avant l'étape b), de formation d'un premier contour sur l'une et/ou l'autre de la face avant et de la face de scellement, le premier contour comprenant une première tranchée, avantageusement continue, présentant une largeur L et une première profondeur p1, la formation du premier contour étant exécutée de sorte qu'à l'issue de l'étape b) la pluralité de cavités soit circonscrite par le premier contour, ledit premier contour étant à une distance G, avantageusement essentiellement constante, de la pluralité de cavités comprise entre un cinquième de b et cinq b, avantageusement entre un demi de b et 2b, encore plus avantageusement entre 0,9xb et 1,1xb.

Selon un mode de mise en œuvre, la largeur L est comprise entre un cinquième de a à cinq a, avantageusement entre un demi de a et 2a, encore plus avantageusement entre 0,9xa et 1,1xa.

Selon un mode de mise en œuvre, les cavités sont de forme carrée, ronde, ou polygonale et notamment de forme hexagonale.

Selon un mode de mise en œuvre, la première profondeur p1 est égale à la profondeur p des cavités.

Selon un mode de mise en œuvre, le premier contour est formé sur la face avant, et l'étape b) est suivie d'une étape c) du retrait partiel du film de scellement (16), de manière à découvrir le premier contour, ledit retrait partiel conservant une section du film de scellement (16) circonscrite au premier contour.

Selon un mode de mise en œuvre, le premier contour est formé sur la face de scellement, et la première profondeur p1 est inférieure à l'épaisseur du film de scellement.

Selon un mode de mise en œuvre, le premier contour est formé sur la face de scellement, et la première profondeur p1 est supérieure ou égale à l'épaisseur du film de scellement de sorte qu'à l'issue de l'étape de b) le premier contour est exposé à l'environnement extérieur.

Selon un mode de mise en œuvre, l'étape a1) comprend également la formation d'au moins un deuxième contour qui comprend une deuxième tranchée ou une série de deuxièmes cavités autour de la première tranchée, avantageusement en tout point, à une distance essentiellement constante du premier contour.

Selon un mode de mise en œuvre, la profondeur de l'au moins un deuxième contour, dite deuxième profondeur p2, est égale à la profondeur p.

Selon un mode de mise en œuvre, le premier contour et l'au moins un deuxième contour sont reliés par un ou plusieurs canaux d'interconnexion.

Selon un mode de mise en œuvre, l'un ou plusieurs canaux d'interconnexion relient deux coins adjacents, respectivement, du premier contour et du deuxième contour.

Selon un mode de mise en œuvre, l'étape b) de report comprend une étape b1) de collage d'un substrat donneur avec le substrat support, le substrat donneur étant pourvu du film de scellement reposant sur un substrat poignée, suivie d'une étape b2) de retrait du substrat poignée.

Selon un mode de mise en œuvre, l'étape b2) comprend une gravure par abrasion mécanique et/ou chimique.

Selon un mode de mise en œuvre, le substrat donneur comprend une couche intermédiaire intercalée entre le substrat poignée et le film de scellement, la couche intermédiaire présentant une sélectivité de gravure par rapport au film de scellement et au substrat poignée.

Selon un mode de mise en œuvre, le substrat donneur comprend une zone de fragilisation délimitant le film de scellement, et configurée pour se fracturer par application d'une contrainte mécanique et/ou un traitement thermique.

Selon un mode de mise en œuvre, la zone de fragilisation est obtenue par implantation d'espèces.

Selon un mode de mise en œuvre, le film de scellement comprend un matériau semi-conducteur, avantageusement le matériau semi-conducteur comprend au moins des éléments choisis parmi : silicium, germanium, alliage de silicium et de germanium, indure de phosphore, un Arséniure de semi-conducteur III-V, un Phosphure de semi-conducteur III-V, ou un Nitrure de semi-conducteur III-V, carbure de silicium.

Selon un mode de mise en œuvre, le film de scellement comprend un matériau métallique, avantageusement le matériau métallique comprend au moins des éléments choisis parmi : aluminium, cuivre, titane, tungstène, siliciure de tungstène, or.

Selon un mode de mise en œuvre, le film de scellement comprend un matériau isolant, avantageusement le matériau isolant comprend au moins des éléments choisis parmi : dioxyde de silicium, nitrure de silicium.

Selon un mode de mise en œuvre, le film de scellement comprend un matériau piézo-électrique, avantageusement le matériau piézo-électrique comprend au moins des éléments choisis parmi : tantalate de lithium, niobate de lithium, nitrure d'aluminium, oxyde de zinc, tantalate de zinc et de plomb.

L'invention concerne également une mise en œuvre du procédé selon l'invention pour la fabrication d'un micro système électromécanique.

Selon un mode de mise en œuvre, le micro système électromécanique est un transducteur ultrasonore capacitif.

L'invention concerne également un dispositif pourvu d'une pluralité de cavités scellées par une pluralité de membranes, le dispositif comprenant :
a) une pluralité de cavités débouchant au niveau d'une face avant d'un substrat support ou au niveau d'une face de scellement d'un film de scellement, les cavités, avantageusement agencées de manière matricielle, présentent une profondeur p, une dimension caractéristique a, qui est la plus grande dimension de cavité, et sont espacées d'un espacement b ;
b) une pluralité de membranes, scellant chacune des cavités, formées par le film de scellement assemblée à la face avant par sa face de scellement ;
le dispositif étant caractérisé en ce qu'il comprend un premier contour d'une largeur L sur l'une et/ou l'autre de la face avant et de la face de scellement, le premier contour comprenant une première tranchée, et est agencé de sorte que la pluralité de cavités soit circonscrite par le premier contour, ledit premier contour étant à une distance G, avantageusement essentiellement constante, de la pluralité de cavités et comprise entre un cinquième de b et cinq b, avantageusement entre un demi de b et 2b, encore plus avantageusement entre 0,9xb et 1,1xb.

### BRÈVE DESCRIPTION DES DESSINS

D'autres caractéristiques et avantages apparaîtront dans la description qui va suivre d'un procédé de scellement de cavités par des membranes, donnés à titre d'exemples non limitatifs, en référence aux dessins annexés dans lesquels :
Les figures 1a, 1b, 1c sont des illustrations des différentes étapes d'un procédé de formation de membranes connu de l'état de la technique ;
Les figures 2a, 2b, 2c sont des illustrations des différentes étapes d'un procédé de formation de membranes connu de l'état de la technique ;
Les figures 3a, 3b, 3c, 3d, 3e sont des illustrations des différentes étapes d'un procédé de formation de membranes connu de l'état de la technique ;
La figure 4a est une image obtenue par interférométrie optique d'une pluralité de membranes agencées de manière matricielle (les niveaux de gris étant fonction de la hauteur) ;
La figure 4b est une représentation graphique de la déformation D (selon l'axe vertical, en « nm ») de membranes en fonction de leur position X (prise croissante du bord vers le centre, axe horizontal, en « µm ») ;
La figure 5 illustre, en fonction des conditions de collage (conditions « 1 », « 2 », « 3 », et « 4 » selon l'axe horizontal), l'amplitude (selon l'axe vertical, en « nm ») observée des déformations des membranes pour des épaisseurs de film de scellement de 1,5 µm (A), de 0,85 µm (B), et de 0,2 µm (C) ;
La figure 6A est une représentation graphique des déformations des membranes (axe vertical, en « nm ») en fonction de la localisation de la membrane sur la matrice (axe horizontal), la courbe D et la courbe E sont associées, respectivement, à une matrice à proximité du bord du substrat receveur et à une matrice à proximité du centre du substrat receveur ;
La figure 6B est une représentation schématique d'un substrat qui comprend un premier agencement E et un deuxième agencement D de membranes ;
Les figures 7a, 7b, 7c sont des illustrations des différentes étapes du procédé selon une première variante d'un premier mode de réalisation de l'invention ;
Les figures 8a, 8b, 8c sont des illustrations des différentes étapes du procédé selon une deuxième variante d'un deuxième mode de réalisation de l'invention ;
La figure 9a représente un agencement matriciel de cavités entouré d'une tranchée ;
La figure 9b est un grandissement du coin supérieur gauche de l'agencement matriciel de la figure 9a ;
Les figures 10a, 10b sont des représentations partielles de la matrice entourée de la première tranchée et d'une deuxième tranchée, respectivement, sans et avec un canal d'interconnexion ;
Les figures 11a, 11b sont des images obtenues par microscopie optique permettant d'observer l'effet de la première tranchée 21 sur la déformation des membranes par rapport à la déformation observée en l'absence de tranchée, notamment, la figure 11a et la figure 11b représentent chacune une image des membranes formées, respectivement, en l'absence de tranchée, et en présence d'une tranchée ;
Les figures 12a, 12b représentent des mesures par interférométrie optique des zones relatives, respectivement, à la figure 11a et à la figure 11b ;
Les figures 13a, 13b sont des illustrations des différentes étapes du procédé selon un premier aspect (selon une première variante) d'un deuxième mode de réalisation de l'invention ;
Les figures 14a, 14b sont des illustrations des différentes étapes du procédé selon le premier aspect (selon une première variante) du deuxième mode de réalisation de l'invention ;
La figure 15 est une illustration de l'étape b) de transfert selon le premier aspect (première et deuxième variante) du deuxième mode de réalisation ;
Les figures 16a, 16b sont des illustrations des différentes étapes du procédé selon un deuxième aspect (selon une deuxième variante) du deuxième mode de réalisation de l'invention ;
Les figures 17a, 17b sont des illustrations des différentes étapes du procédé selon le deuxième aspect (selon une deuxième variante) du deuxième mode de réalisation de l'invention ;
La figure 18 est une illustration de l'étape b) de transfert selon le deuxième aspect (première et deuxième variante) du deuxième mode de réalisation ;
Les figures 19a, 19b sont des illustrations des différentes étapes du procédé selon un troisième aspect (selon une deuxième variante) du deuxième mode de réalisation de l'invention ;
La figure 20 est une illustration de l'étape b) de transfert selon le troisième aspect (première et deuxième variante) du deuxième mode de réalisation ;
La figure 21a est une représentation schématique d'un agencement de cavités entourées par une première tranchée discontinue, et en particulier pourvue de quatre sections droites disposées chacune à proximité d'un côté de l'agencement de cavités ;
La figure 21b est une représentation schématique d'un agencement de cavités entourées par une première tranchée discontinue, et en particulier pourvue de quatre sections droites discontinues disposées chacune à proximité d'un côté de l'agencement de cavités ;
La figure 22 représente graphiquement une moyenne de déformation de membranes (en « nm » sur l'axe vertical) en fonction de l'espacement b (en « µm », axe horizontal).

### EXPOSÉ DÉTAILLÉ DE MODES DE RÉALISATION PARTICULIERS

La présente invention propose un procédé de scellement de cavités, par exemple agencées de manière matricielle, par des membranes. Le procédé selon la présente invention comprend notamment le report d'un film de scellement, destiné à former les membranes.

Par ailleurs, afin d'assurer une déformation limitée et plus uniforme des membranes scellant les cavités, le procédé selon la présente invention comprend une étape de formation d'un premier contour, qui comprend une première tranchée, avantageusement continue, entourant l'agencement de cavités.

Les figures 7a-7c à 8a-8c illustrent les différentes étapes du procédé de fabrication de scellement de cavités selon un premier mode de réalisation de la présente invention.

Le procédé comprend notamment une étape a) de formation d'une pluralité de cavités 11 débouchant au niveau d'une face avant 10a d'un substrat support 10 (figure 7a).

La suite de l'énoncé concerne également la mise en œuvre d'un film de scellement destiné à être reporté par une de ses faces, dite face de scellement, sur la face avant 10a. Selon un autre aspect de ce premier mode de réalisation, il pourra être considéré de former la pluralité de cavités 11 sur le film de scellement, et notamment des cavités débouchant au niveau de la face de scellement. L'homme du métier, à la seule lecture de la description qui suit, sera en mesure de mettre en œuvre cet autre aspect.

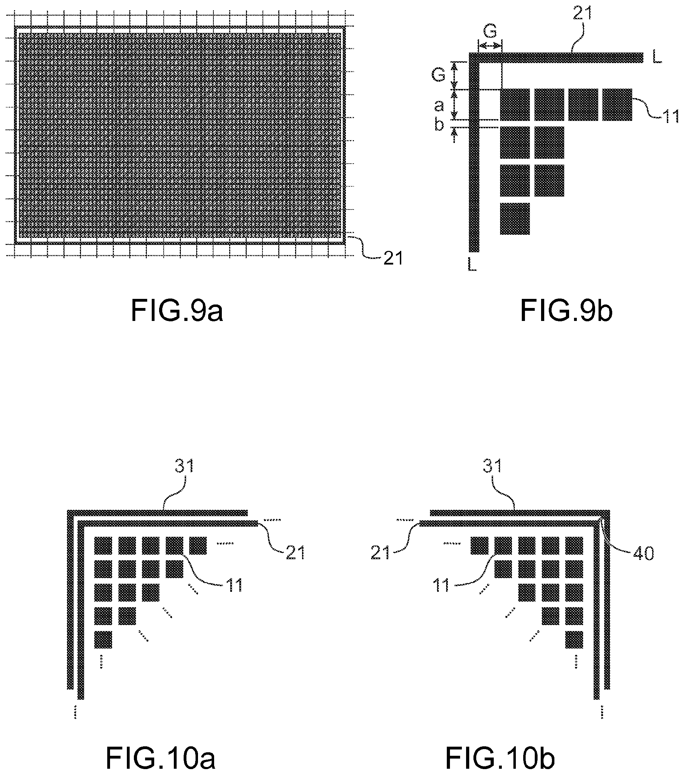

Les cavités 11 peuvent, par exemple, être agencées de manière matricielle (figure 9a).

Par « agencement matriciel », on entend un agencement régulier selon deux directions différentes, par exemple orthogonales, de cavités 11 identiques. L'agencement matriciel peut comprendre notamment n lignes et m colonnes des cavités 11.

Un agencement matriciel selon la présente invention n'est ainsi pas limité à un agencement périodique selon deux directions orthogonales de lignes et de colonnes. L'agencement matriciel peut comprendre d'autres formes de matrices, comme par exemple un agencement hexagonal, ou encore un agencement à symétrie circulaire organisé en cercles concentriques.

Les cavités 11 présentent une profondeur p, une dimension caractéristique a, et sont espacées d'un espacement b. Par exemple, dès lors qu'un agencement selon une matrice rectangulaire est considéré, l'espacement b est défini selon l'une et l'autre des directions définies par les colonnes et les lignes de la matrice de cavités (figure 9b).

L'espacement b, selon la présente invention, correspond à un espacement moyen des cavités d'un agencement désordonné par exemple.

Par « dimension caractéristique », on entend la plus grande dimension de l'ouverture de la cavité. L'ouverture peut être de forme circulaire, carrée, rectangulaire, ou plus généralement à n côtés, et par exemple polygonale, notamment triangulaire ou hexagonale.

La forme d'une cavité selon la présente invention est définie par la forme de son ouverture.

À titre d'exemple, les cavités 11 peuvent présenter une forme carrée de côté a compris entre 0,5 µm et 500 µm, et une profondeur p comprise entre 10 nm et 10 µm.

L'espacement b est avantageusement compris entre 1µm et 500µm.

L'agencement matriciel peut comprendre plusieurs centaines, voire plusieurs milliers, de cavités.

Il est entendu qu'un agencement est délimité par un contour défini par les cavités périphériques dudit agencement (figure 9a).

Le substrat support peut comprendre un matériau semi-conducteur, avantageusement le matériau semi-conducteur comprend au moins des éléments choisis parmi : silicium, germanium, alliage de silicium et de germanium, indure de phosphore, un Arséniure de semi-conducteur III-V, un Phosphure de semi-conducteur III-V, ou un Nitrure de semi-conducteur III-V, carbure de silicium.

Le substrat support peut comprendre un matériau métallique, avantageusement le matériau métallique comprend au moins des éléments choisis parmi : aluminium, cuivre, titane, tungstène, siliciure de tungstène, or.

Le substrat support peut comprendre un matériau isolant, avantageusement le matériau isolant comprend au moins des éléments choisis parmi : dioxyde de silicium, nitrure de silicium.

Le film de scellement peut comprendre un matériau piézo-électrique, avantageusement le matériau piézo-électrique comprend au moins des éléments choisis parmi : tantalate de lithium, niobate de lithium, nitrure d'aluminium, oxyde de zinc, tantalate de zinc et de plomb.

L'étape a) peut notamment comprendre une étape de masquage permettant de délimiter le contour des cavités 11, et une étape de gravure.

L'étape de masquage peut impliquer la formation d'un masque dur (« hard mask » selon la terminologie Anglo-Saxonne), et notamment un masque de dioxyde de silicium.

L'étape de gravure peut comprendre une gravure sèche (par exemple une gravure impliquant un plasma) ou une gravure humide.

Le procédé comprend également une étape a1) de formation d'un premier contour.

Par « premier contour », on entend un chemin, avantageusement un chemin fermé, formé par une ou plusieurs structures en retrait par rapport à la face du support sur lequel elle(s) est/sont formée(s). Le premier contour présente notamment une largeur L définie par la ou les structures.

La largeur L du contour tout au long de la description correspond à une largeur moyenne. Plus particulièrement, les parois latérales de la tranchée formant le contour peuvent présenter un écartement qui varie. Par exemple, l'une et/ou l'autre de ces parois peut dessiner un profil en dents de scie, ou présenter des irrégularités à l'origine des variations de largeur.

Par « en retrait », on entend que la ou les structure(s) présente(nt) une première profondeur p1.

Le premier contour peut comprendre une ou plusieurs premières tranchées, avantageusement continues.

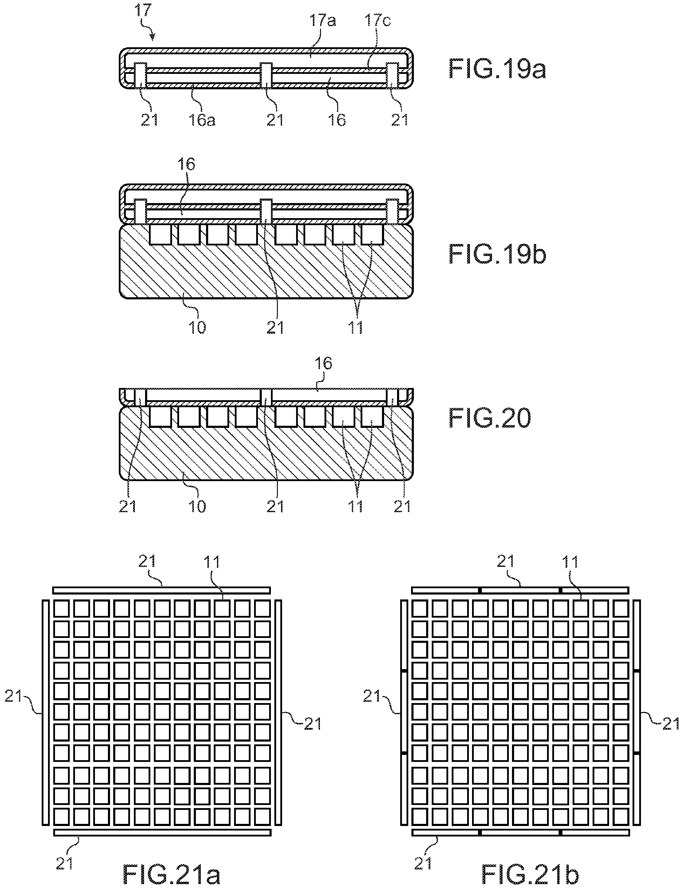

Les figures 21a et 21b représentent un premier contour formé par une première tranchée discontinue, et qui peut comprendre notamment quatre sections, chacune à proximité d'un côté de l'agencement des cavités.

La suite de l'énoncé de ce premier mode de réalisation se limitera à un premier contour formé par une première tranchée continue.

Selon ce premier mode de réalisation, la première tranchée 21 est formée sur le substrat support 10, et débouche au niveau de la face avant 10a.

En particulier, la première tranchée entoure l'agencement de cavités.

La première tranchée 21 présente une largeur L, et est à une distance G essentiellement constante de l'agencement de cavités 11.

En d'autres termes, la première tranchée a la même forme que le contour dudit agencement.

La distance G, tout au long de la description, représente une distance moyenne. Plus particulièrement, des variations de distance entre le premier contour et l'agencement de cavités peuvent être observées.

La première tranchée 21 est d'une première profondeur p1 avantageusement égale à la profondeur p.

De manière avantageuse, l'étape a1) et l'étape a) sont exécutées de manière simultanée.

Selon un mode préféré de la présente invention, la distance G est comprise entre un cinquième de b (b/5) et cinq b (5xb), avantageusement entre un demi de b (0,5xb) et deux b (2xb), encore plus avantageusement entre 0,9xb et 1,1xb.

Le procédé selon la présente invention comprend également une étape b) de formation de membranes 19 scellant chacune des cavités 11.

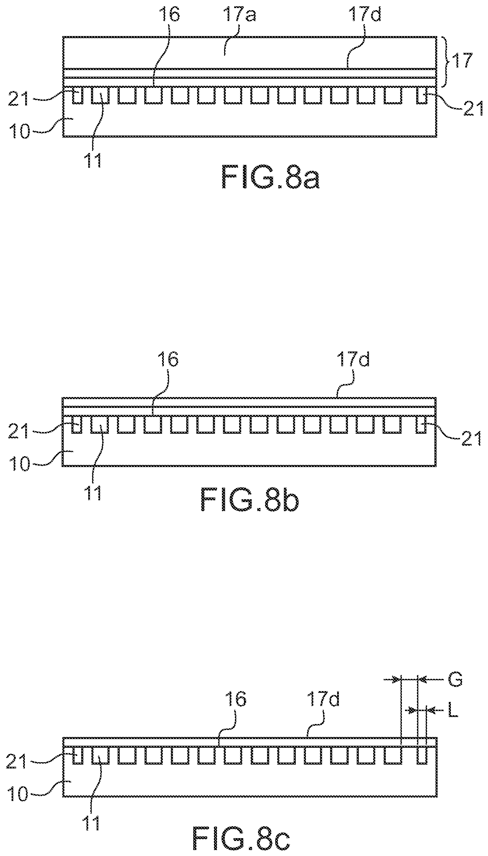

L'étape b) de formation de membranes 19 comprend notamment le report du film de scellement 16 sur la face avant 10a du substrat support 10, et de la première tranchée 21 (figures 7b, 7c, 8a, 8b et 8c).

Plus particulièrement, le report comprend l'assemblage de la face de scellement 16a du film de scellement 16 avec la face avant 10a.

En d'autres termes, le film de scellement 16 scelle de manière hermétique la première tranchée 21 et les cavités 11.

Les membranes 19 sont ainsi en suspension au-dessus des cavités 11.

Le film de scellement 16 peut comprendre un matériau semi-conducteur, avantageusement le matériau semi-conducteur comprend au moins des éléments choisis parmi : silicium, germanium, alliage de silicium et de germanium, indure de phosphore, un Arséniure de semi-conducteur III-V, un Phosphure de semi-conducteur III-V, ou un Nitrure de semi-conducteur III-V, carbure de silicium.

Le film de scellement 16 peut comprendre un matériau métallique, avantageusement le matériau métallique comprend au moins des éléments choisis parmi : aluminium, cuivre, titane, tungstène, siliciure de tungstène, or.

Le film de scellement 16 peut comprendre un matériau isolant, avantageusement le matériau isolant comprend au moins des éléments choisis parmi : dioxyde de silicium, nitrure de silicium.

Le film de scellement 16 comprend un matériau piézo-électrique, avantageusement le matériau piézo-électrique comprend au moins des éléments choisis parmi : tantalate de lithium, niobate de lithium, nitrure d'aluminium, oxyde de zinc, tantalate de zinc et de plomb.

Le film de scellement 16 peut également comprendre un empilement de couches, et notamment un empilement de LTO et de Si.

Le report du film de scellement peut notamment impliquer une étape b1) de collage d'un substrat, dit substrat donneur 17, sur la face avant 10a, et une étape b2) de retrait d'une première partie, dite substrat poignée 17a, du substrat donneur 17 de manière à ne conserver qu'une seconde partie dudit substrat formant le film de scellement 16 (figures 7b et 8a).

Il est entendu que l'étape b1) de collage peut comprendre un collage moléculaire (ou direct) ou un collage par thermocompression ou un collage eutectique.

L'étape de collage b1) peut également être exécutée sous vide ou sous une atmosphère contrôlée notamment pour imposer un gaz et une pression prédéterminées dans les cavités 11 scellées par le film de scellement 16.

Plus généralement, tout mode de collage connu de l'homme du métier peut être mis en œuvre dans le cadre de la présente invention.

Selon une première variante de ce premier mode de mise en œuvre, l'étape b2) peut comprendre une étape d'amincissement (figures 7a à 7c).

L'étape d'amincissement peut notamment comprendre une gravure humide, une gravure sèche, ou encore une abrasion mécanique (« Grinding » selon la terminologie Anglo-Saxonne).

À titre d'exemple, un substrat poignée 17a comprenant du silicium peut être gravé par voie humide avec une solution de KOH ou encore de TMAH.

De manière particulièrement avantageuse et dans le cadre de ce premier mode de réalisation, le substrat donneur 17 comprend une couche intermédiaire 17c intercalée entre le substrat poignée 17a et le film de scellement 16.

La couche intermédiaire 17c présente notamment une sélectivité face à la gravure au regard du film de scellement 16. Il est ainsi possible de considérer une épaisseur de film de scellement 16 inférieure à 20 µm, voire 10 µm, par exemple égale à 5 µm.

Le substrat donneur 17, selon cette alternative, peut notamment être un substrat de silicium sur isolant (« SOI »), la couche d'isolant étant la couche intermédiaire. La couche de silicium du substrat SOI est avantageusement fortement dopée. La couche d'arrêt peut être gravée par abrasion ou par une étape de gravure chimique sélective.

Selon une deuxième variante du premier mode de réalisation, l'étape b1) peut être précédée d'une étape de formation d'une zone de fragilisation 17d délimitant le film de scellement dans le substrat donneur. La zone de fragilisation est notamment une zone au niveau de laquelle une fracture du substrat donneur 17 est susceptible de se produire, lors de l'exécution de l'étape b2), sous l'effet d'un traitement thermique et/ou d'une action mécanique (figure 8a à 8c).

La zone de fragilisation 17d peut être une zone amorphisée ou une zone implantée, notamment une zone implantée avec des atomes d'hydrogène.

Quel que soit la variante considérée, l'étape a1) peut également comprendre la formation d'au moins un deuxième contour 31. Le deuxième contour peut notamment comprendre, à l'instar du premier contour 21, une deuxième tranchée, avantageusement continue.

La deuxième tranchée 31 forme un contour, par exemple fermé, autour de la première tranchée 21 avantageusement en tout point à une distance essentiellement constante de la première tranchée 21 (figure 10a et 10b).

La profondeur de l'au moins une deuxième tranchée 31, dite deuxième profondeur p2, peut être égale à la profondeur p.

La première tranchée 21 et l'au moins une deuxième tranchée 31 peuvent être reliées par un ou plusieurs canaux d'interconnexion 40. Notamment, l'un ou plusieurs canaux d'interconnexion peuvent relier deux coins adjacents, respectivement, de la première tranchée et de la deuxième tranchée (figure 10b).

De manière particulièrement avantageuse, le film de scellement reporté lors de l'étape b) scelle également l'au moins une deuxième tranchée.

La considération de la première tranchée 21, et éventuellement de l'au moins une deuxième tranchée 31, permet de réduire la non uniformité en termes de déformation des membranes susceptible d'être observée entre le centre et le bord de l'agencement matriciel.

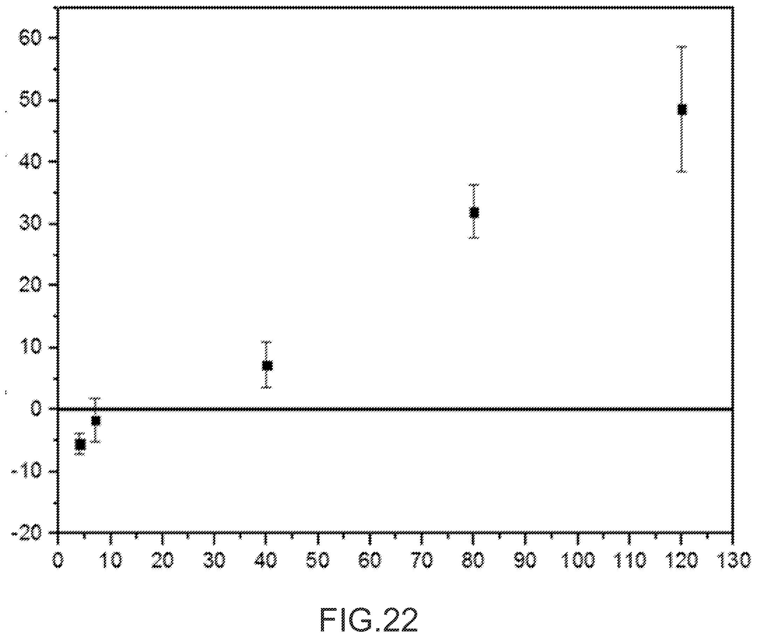

En particulier, les inventeurs ont pu démontrer que la distance G a une incidence directe sur l'uniformité de déflexion des membranes circonscrites par le premier contour 21. Notamment, après scellement des cavités, et plus particulièrement lors des traitements thermiques, des espèces sont susceptibles de diffuser à l'interface de collage. A cet égard, les cavités peuvent jouer le rôle de réservoirs. Aussi, plus l'aire de la surface collée entourant la cavité est importante et plus la déformation de la membrane transférée sera grande. En d'autres termes, la distance G peut être définie, en fonction des contraintes d'intégration (prises de contacts ultérieures, ...), de la distance b séparant les cavités du réseau et de l'uniformité recherchée. Ainsi, une distance G sera proche de b meilleure permettra d'obtenir une meilleure uniformité de déformation des membranes. Au contraire, la considération d'une distance G supérieure à b n'aura que peut, voire pas, d'effet bénéfique. La figure 22 est en une parfaite illustration. Cette dernière représente graphiquement une moyenne de déformation de membranes (en « nm » sur l'axe vertical) en fonction de l'espacement b. Il est à cet égard notable que la déformation croit avec l'espacement b.

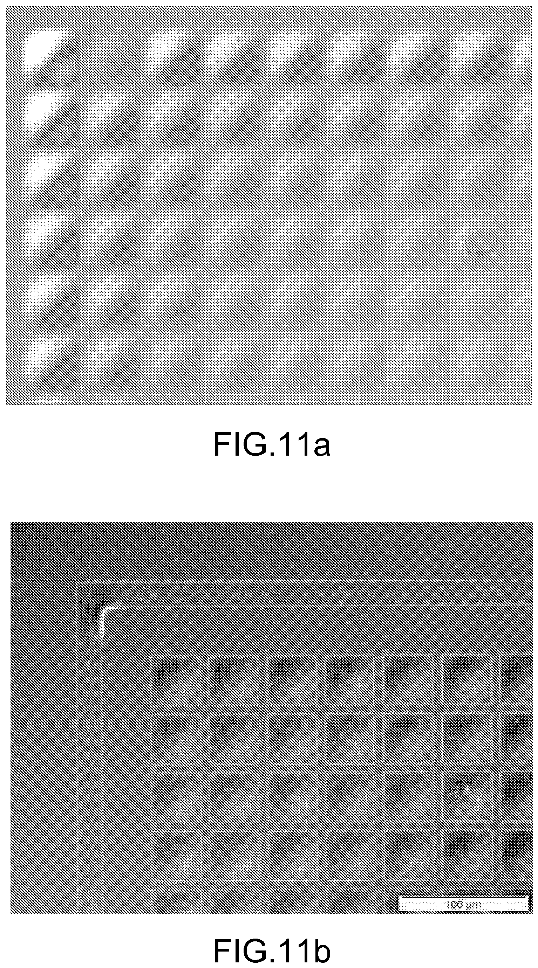

Par ailleurs, les figures 11a et 11b sont des images obtenues par microscopie optique permettant d'observer l'effet de la première tranchée 21 sur la déformation des membranes par rapport à la déformation observée en l'absence de cette dernière.

La comparaison de ces figures révèle clairement l'effet bénéfique de la première tranchée 21 sur la non uniformité de la déformation des membranes. Notamment, la première tranchée permet de réduire la non uniformité de la déformation des membranes.

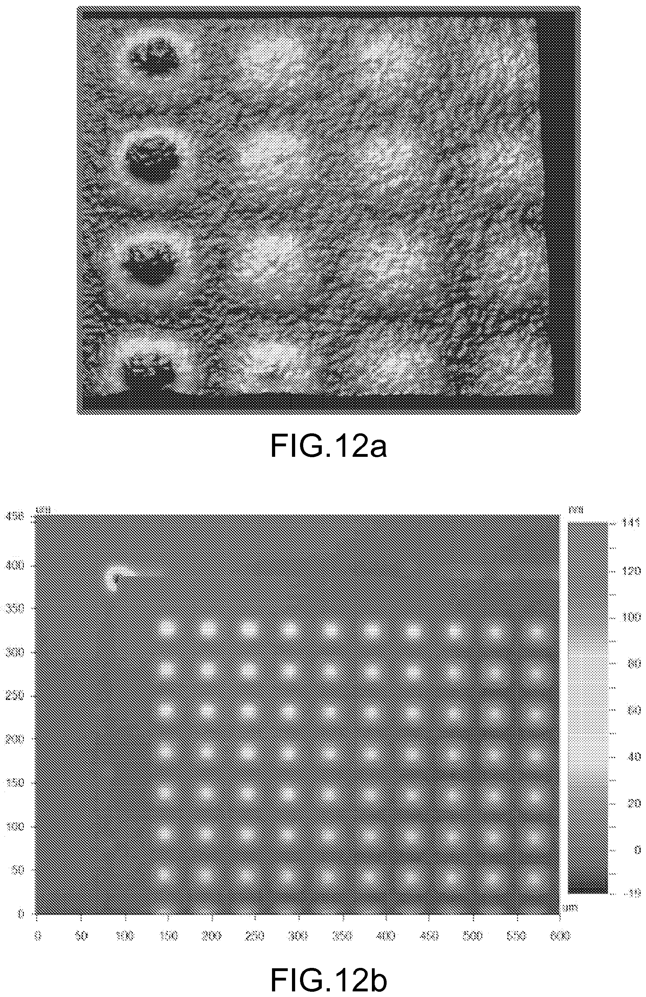

Les figures 12a et 12b, qui mènent aux mêmes conclusions, représentent des mesures par interférométrie optique des zones relatives, respectivement, à la figure 11a et à la figure 11b. Notamment, l'amplitude de déformation des membranes est bien plus homogène d'une membrane à l'autre à la figure 12b.

Le procédé selon la présente invention peut également comprendre une étape c), exécutée après l'étape b), de retrait d'une section du film de scellement en recouvrement de la première tranchée et/ou de l'au moins une deuxième tranchée.

En d'autres termes, à l'issue de l'étape c), le film scellement est conservé sur les cavités, et est retiré au niveau de la première tranchée et/ou de l'au moins une deuxième tranchée.

Cette étape c) de retrait peut comprendre une gravure humide ou une gravure sèche.

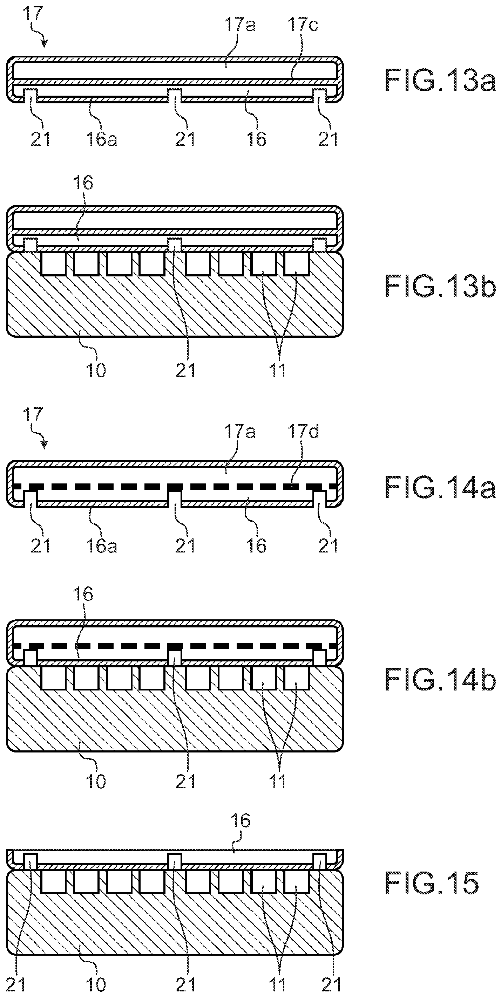

Les figures 13a, 13b, 14a, 14b et 15 illustrent les différentes étapes du procédé de fabrication de scellement de cavités selon un premier aspect d'un deuxième mode de réalisation de la présente invention.

Le deuxième mode de fabrication diffère, à cet égard, du premier mode en ce que le premier contour 21, ainsi que le deuxième contour 31 s'il est considéré, sont formés dans le film de scellement 16. En particulier, le premier contour 21 est limité dans la suite de l'énoncé à la première tranchée.

Un premier aspect de ce deuxième mode de réalisation est illustré aux figures 13a, 13b, 14a, 14b et 15.

Plus particulièrement, le procédé illustré aux figures 13a et 13b reprend les termes de la première variante du premier mode de réalisation, tandis que le procédé illustré aux figures 14a et 14b reprend les termes de la deuxième variante du premier mode de réalisation.

Les figures 13a et 14a représentent un substrat donneur 17 sur une face duquel (la face de scellement 16a) est formé le premier contour 21.

Selon cette variante, le premier contour 21 présente une première profondeur inférieure à l'épaisseur du film de scellement.

Le substrat support 10, au niveau duquel est formé l'agencement de cavités 11 est ensuite assemblé avec le substrat donneur 17 (figures 13b et 14b).

À l'issue de l'étape b), représentée à la figure 15, l'agencement de cavités 11 se retrouve circonscrit par la première tranchée 21.

Quel que soit le mode de réalisation ou la variante envisagée, par « circonscrit », on entend que la projection de la première tranchée sur la face avant entoure l'agencement de cavités.

Il est possible d'amincir le film de scellement 16 de manière à découvrir la première tranchée 21.

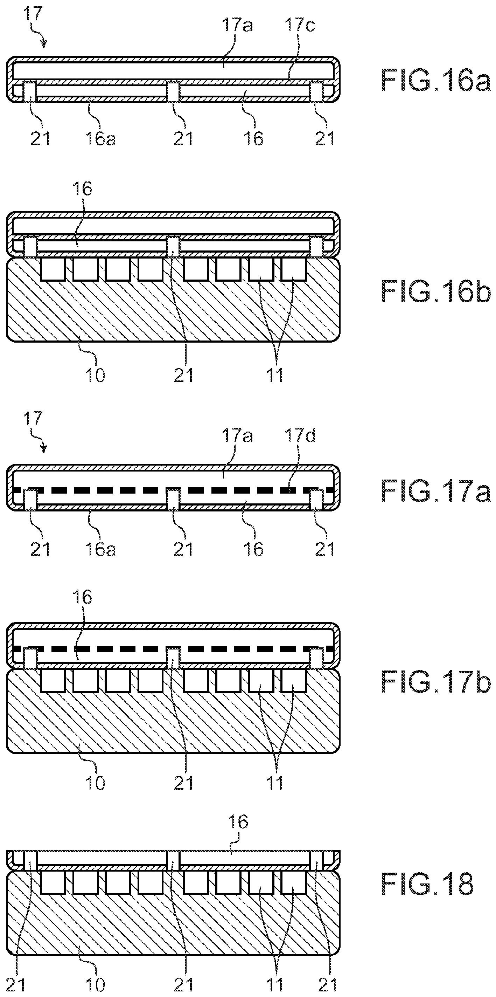

Une deuxième variante du deuxième mode de réalisation est illustrée aux figures 16a, 16b, 17a, 17b et 18.

Selon cette deuxième variante, la première tranchée 21 présente une profondeur supérieure à l'épaisseur du film de scellement de sorte qu'à l'issue de l'étape de transfert, ladite première tranchée 21 est exposée à l'environnement extérieur (figure 21).

Le procédé illustré aux figures 16a et 16b reprend les termes de la première variante du premier mode de réalisation, tandis que le procédé illustré aux figures 17a et 17b reprend les termes de la deuxième variante du premier mode de réalisation.

Les figures 16a et 17a représentent un substrat donneur 17 sur une face duquel (la face de scellement 16a) est formé le premier contour 21.

Le substrat support 10, au niveau duquel est formé l'agencement de cavités 11 est ensuite assemblé avec le substrat donneur 17 (figures 16b et 17b).

Les figures 19a, 19b, 20 illustrent les différentes étapes du procédé de fabrication de scellement de cavités selon un troisième aspect du deuxième mode de réalisation de la présente invention.

Selon ce troisième aspect, la profondeur de la première tranchée est supérieure à l'épaisseur du film de scellement 16.

Notamment, les étapes du procédé illustrées aux figures 19a et 19b reprennent les termes du procédé illustré aux figures 16a et 16b.La considération de la première tranchée et/ou de l'au moins une deuxième tranchée permet d'amortir la déformation des membranes susceptible de se produire lors du report du film de scellement, et par voie de conséquence de réduire également la non uniformité de déformation.

Le procédé selon la présente invention est avantageusement mis en œuvre pour la fabrication de MEMS, et notamment des MEMS impliquant des résonateurs formés chacun par un couple membrane/cavité.

La réduction de la déformation subie par les membranes conduit à une augmentation du facteur de qualité combiné de l'agencement matriciel de résonateur, et permet ainsi de fabriquer un agencement matriciel de transducteurs ultrasonores capacitifs (« cMUT » ou « capacitive micromachined ultrasound transducers » selon la terminologie Anglo-Saxonne) bien plus sensibles que les agencements connus de l'état de la technique.

Le procédé selon la présente invention peut également être mis en œuvre pour la fabrication de substrats démontables dont la couche de scellement en recouvrement des cavités peut être détachée. L'énergie impliquant le détachement entre le substrat receveur et le film de scellement peut être ajustée en fonction des caractéristiques dimensionnelles de l'agencement matriciel et des cavités.

Quelle que soit l'application envisagée, le procédé selon la présente invention permet d'exécuter des étapes technologiques (telles que des étapes de photolithographie, de collage, de gravure, de dépôt de film) subséquentes.

Il est enfin entendu que le premier contour et/ou le deuxième contour peuvent être formés à la fois sur la face avant 10a et la face de scellement 16a.

La présente invention concerne également un dispositif pourvu d'une pluralité de cavités 11 scellées par une pluralité de membranes 19, le dispositif comprenant :
a) une pluralité de cavités 11 débouchant au niveau d'une face avant 10a d'un substrat support 10 ou au niveau d'une face de scellement d'un film de scellement, les cavités 11, avantageusement agencées de manière matricielle, présentent une profondeur p, une dimension caractéristique a, et sont espacées d'un espacement b ;
b) une pluralité de membranes 19, scellant chacune des cavités 11, formées par le film de scellement 16 assemblé avec la face avant 10a par sa face de scellement ;
le dispositif comprend en outre un premier contour d'une largeur L sur l'une et/ou l'autre de la face avant 10a et de la face de scellement, le premier contour comprenant une première tranchée 21, avantageusement continue, et est agencé de sorte que la pluralité de cavités 11 soit circonscrite par le premier contour, ledit premier contour étant à une distance G, avantageusement essentiellement constante, de la pluralité de cavités et comprise entre un cinquième de b (b/5) à cinq b (5xb), avantageusement entre un demi de b (0,5xb) et deux b (2xb), encore plus avantageusement entre 0,9xb et 1,1xb.

## Revendications

1. Procédé de scellement d'une pluralité de cavités (11) par une pluralité de membranes (19), le procédé comprenant les étapes suivantes :
a) une étape de formation d'une pluralité de cavités (11) débouchant au niveau d'une face avant (10a) d'un substrat support (10) ou au niveau d'une face de scellement (16a) d'un film de scellement (16), les cavités (11), avantageusement agencées de manière matricielle, présentent une profondeur p, une dimension caractéristique a, qui est la plus grande dimension de cavité, et sont espacées d'un espacement b ;
b) une étape de formation d'une pluralité de membranes (19), scellant chacune des cavités (11), par report du film de scellement (16) en recouvrement de la face avant (10a) le report comprenant l'assemblage de la face de scellement (16a) avec la face avant (10a) ;
une étape a1), exécutée avant l'étape b), de formation d'un premier contour sur l'une et/ou l'autre de la face avant (10a) et de la face de scellement (16a), le premier contour comprenant une première tranchée (21), avantageusement continue, présentant une largeur L et une première profondeur p1, la formation du premier contour étant exécutée de sorte qu'à l'issue de l'étape b) la pluralité de cavités (11) soit circonscrite par le premier contour ;
le procédé étant **caractérisé en ce que** ledit premier contour est à une distance G, avantageusement essentiellement constante, de la pluralité de cavités comprise entre un cinquième de b et cinq b, avantageusement entre un demi de b et deux b, encore plus avantageusement entre 0,9xb et 1,1xb.

2. Procédé selon la revendication 1, dans lequel la largeur L est comprise entre un cinquième de a et cinq a, avantageusement entre un demi de a et deux a, encore plus avantageusement entre 0,9xa et 1,1xa.

3. Procédé selon la revendication 1 ou 2, dans lequel les cavités (11) sont de forme carrée, ronde, ou polygonale et notamment de forme hexagonale.

4. Procédé selon l'une des revendications 1 à 3, dans lequel le premier contour est formé :
- sur la face avant, et l'étape b) est suivie d'une étape c) du retrait partiel du film de scellement (16) de manière à découvrir le premier contour, ledit retrait partiel conservant une section du film de scellement (16) circonscrite par le premier contour ;
- et/ou sur la face de scellement, et la première profondeur p1 est inférieure à l'épaisseur du film de scellement ;
- ou sur la face de scellement, et la première profondeur p1 est supérieure ou égale à l'épaisseur du film de scellement de sorte qu'à l'issue de l'étape de b) le premier contour est exposé à l'environnement extérieur.

5. Procédé selon l'une des revendications 1 à 4, dans lequel l'étape a1) comprend également la formation d'au moins un deuxième contour, sur l'une et/ou l'autre de la face avant (10a) et de la face de scellement (16a), qui comprend une deuxième tranchée (31) autour de la première tranchée (21), avantageusement en tout point, à une distance essentiellement constante du premier contour.

6. Procédé selon la revendication 5, dans lequel le premier contour et l'au moins un deuxième contour sont reliés par un ou plusieurs canaux d'interconnexion (40), avantageusement, l'un ou plusieurs canaux d'interconnexion (40) relient deux coins adjacents, respectivement, du premier contour et du deuxième contour.

7. Procédé selon l'une des revendications 1 à 6, dans lequel l'étape b) de report comprend une étape b1) de collage d'un substrat donneur (17) avec le substrat support (10), le substrat donneur (17) étant pourvu du film de scellement (16) reposant sur un substrat poignée (17a), suivie d'une étape b2) de retrait du substrat poignée (17a).

8. Procédé selon la revendication 7, dans lequel l'étape b2) comprend une gravure par abrasion mécanique et/ou chimique.

9. Procédé selon la revendication 8, dans lequel le substrat donneur (17) comprend une couche intermédiaire (17c) intercalée entre le substrat poignée (17a) et le film de scellement (16), le couche intermédiaire (17c) présentant une sélectivité de gravure par rapport au film de scellement (16) et au substrat poignée (17a).

10. Procédé selon la revendication 7, dans lequel le substrat donneur (17) comprend une zone de fragilisation (17d) délimitant le film de scellement (16), et configurée pour se fracturer par application d'une contrainte mécanique et un traitement thermique.

11. Procédé selon la revendication 10, dans lequel la zone de fragilisation (17d) est obtenue par implantation d'espèces.

12. Procédé selon l'une des revendications 1 à 11, dans lequel le film de scellement (16) comprend un matériau semi-conducteur, avantageusement le matériau semi-conducteur comprend au moins des éléments choisis parmi : silicium, germanium, alliage de silicium et de germanium, indure de phosphore, un Arséniure de semi-conducteur III-V, un Phosphure de semi-conducteur III-V, ou un Nitrure de semi-conducteur III-V, carbure de silicium.

13. Procédé selon l'une des revendications 1 à 11, dans lequel le film de scellement (16) comprend :
- un matériau métallique, avantageusement le matériau métallique comprend au moins des éléments choisis parmi : aluminium, cuivre, titane, tungstène, siliciure de tungstène, or ;
- ou un matériau isolant, avantageusement le matériau isolant comprend au moins des éléments choisis parmi : dioxyde de silicium, nitrure de silicium ;
- ou un matériau piézo-électrique, avantageusement le matériau piézo-électrique comprend au moins des éléments choisis parmi : tantalate de lithium, niobate de lithium, nitrure d'aluminium, oxyde de zinc, tantalate de zinc et de plomb.

14. Mise en œuvre du procédé selon l'une des revendications 1 à 13 pour la fabrication d'un micro système électromécanique.

15. Dispositif pourvu d'une pluralité de cavités (11) scellées par une pluralité de membranes (19), le dispositif comprenant :
a) une pluralité de cavités (11) débouchant au niveau d'une face avant (10a) d'un substrat support (10) ou au niveau d'une face de scellement d'un film de scellement, les cavités (11), avantageusement agencées de manière matricielle, présentent une profondeur p, une dimension caractéristique a, qui est la plus grande dimension de cavité, et sont espacées d'un espacement b ;
b) une pluralité de membranes (19), scellant chacune des cavités (11), formées par le film de scellement (16) assemblée à la face avant (10a) par sa face de scellement ;
un premier contour d'une largeur L sur l'une et/ou l'autre de la face avant (10a) et de la face de scellement, le premier contour comprenant une première tranchée (21), et est agencé de sorte que la pluralité de cavités (11) soit circonscrite par le premier contour ;
le dispositif étant **caractérisé en ce que**
ledit premier contour est à une distance G, avantageusement essentiellement constante, de la pluralité de cavités et comprise entre un cinquième de b et cinq b, avantageusement entre un demi de b et deux b, encore plus avantageusement entre 0,9xb et 1,1xb.

## Patentansprüche

1. Verfahren zum Versiegeln einer Vielzahl von Hohlräumen (11) durch eine Vielzahl von Membranen (19), wobei das Verfahren die folgenden Schritte umfasst:
a) einen Schritt zum Bilden einer Vielzahl von Hohlräumen (11), die im Bereich einer Vorderseite (10a) eines Trägersubstrats (10) oder im Bereich einer Versiegelungsseite (16a) einer Versiegelungsfolie (16) einmünden, wobei die Hohlräume (11), die vorteilhafterweise matrixförmig angeordnet sind, eine Tiefe p, eine charakteristische Abmessung a, welche die größte Hohlraumabmessung ist, aufweisen und um einen Abstand b beabstandet sind;
b) einen Schritt zum Bilden einer Vielzahl von Membranen (19), die jeden der Hohlräume (11) versiegeln, durch Übertragen der Versiegelungsfolie (16) zur Überdeckung der Vorderseite (10a), wobei der Übertrag das Zusammenfügen der Versiegelungsseite (16a) mit der Vorderseite (10a) umfasst;
einen Schritt a1), der vor dem Schritt b) ausgeführt wird, zum Bilden einer ersten Kontur an der einen und/oder anderen der Vorderseite (10a) und der Versiegelungsseite (16a), wobei die erste Kontur einen ersten vorteilhafterweise durchgehenden Graben (21) umfasst, eine Breite L und eine erste Tiefe p1 aufweist, wobei das Bilden der ersten Kontur ausgeführt ist, sodass nach Abschluss des Schrittes b) die Vielzahl von Hohlräumen (11) von der ersten Kontur umgeben ist;
wobei das Verfahren **dadurch gekennzeichnet ist, dass** die erste Kontur einen vorteilhaft im Wesentlichen konstanten Abstand G von der Vielzahl von Hohlräumen hat, der zwischen einem Fünftel von b und fünf b, vorteilhafterweise zwischen einer Hälfte von b und zwei b, noch vorteilhafter zwischen 0,9xb und 1,1xb liegt.

2. Verfahren nach Anspruch 1, wobei die Breite L zwischen einem Fünftel von a und fünf a, vorteilhafterweise zwischen einer Hälfte von a und zwei a, noch vorteilhafter zwischen 0,9xa und 1,1xa liegt.

3. Verfahren nach Anspruch 1 oder 2, wobei die Hohlräume (11) quadratisch, rund oder polygonal und insbesondere sechseckig geformt sind.

4. Verfahren nach einem der Ansprüche 1 bis 3, wobei die erste Kontur gebildet ist:
- auf der Vorderseite, und auf Schritt b) ein Schritt c) zum teilweisen Entfernen der Versiegelungsfolie (16) folgt, um die erste Kontur freizulegen, wobei das teilweise Entfernen einen von der ersten Kontur umgebenen Abschnitt der Versiegelungsfolie (16) beibehält;
- und/oder auf der Versiegelungsseite, und die erste Tiefe p1 geringer ist als die Dicke der Versiegelungsfolie;
- oder auf der Versiegelungsseite, und die erste Tiefe p1 größer oder gleich der Dicke der Versiegelungsfolie ist, sodass nach Abschluss des Schrittes b) die erste Kontur der Außenumgebung ausgesetzt ist.

5. Verfahren nach einem der Ansprüche 1 bis 4, wobei der Schritt a1) auch das Bilden mindestens einer zweiten Kontur, auf der einen und/oder der anderen der Vorderseite (10a) und der Versiegelungsseite (16a), umfasst, die einen zweiten Graben (31) um den ersten Graben (21), vorteilhafterweise an jedem Punkt, in einem im Wesentlichen konstanten Abstand zur ersten Kontur umfasst.

6. Verfahren nach Anspruch 5, wobei die erste Kontur und die mindestens eine zweite Kontur durch einen oder mehrere Verbindungskanäle (40) verbunden sind, vorteilhafterweise der eine oder mehrere Verbindungskanäle (40) jeweils zwei benachbarte Ecken der ersten Kontur und der zweiten Kontur verbinden.

7. Verfahren nach einem der Ansprüche 1 bis 6, wobei der Schritt b) zum Übertragen einen Schritt b1) zum Verkleben eines Spendersubstrats (17) mit dem Trägersubstrat (10) umfasst, wobei das Spendersubstrat (17) mit der auf einem Griffsubstrat (17a) aufliegenden Versiegelungsfolie (16) versehen ist, gefolgt von einem Schritt b2) zum Entfernen des Griffsubstrats (17a).

8. Verfahren nach Anspruch 7, wobei Schritt b2) ein Ätzen durch mechanischen und/oder chemischen Abrieb umfasst.

9. Verfahren nach Anspruch 8, wobei das Spendersubstrat (17) eine Zwischenschicht (17c) umfasst, die zwischen dem Griffsubstrat (17a) und der Versiegelungsfolie (16) eingelegt ist, wobei die Zwischenschicht (17c) eine Ätzselektivität in Bezug auf die Versiegelungsfolie (16) und das Griffsubstrat (17a) aufweist.

10. Verfahren nach Anspruch 7, wobei das Spendersubstrat (17) eine Bruchzone (17d) umfasst, welche die Versiegelungsfolie (16) begrenzt, und konfiguriert ist, um durch Anlegen einer mechanischen Beanspruchung und einer Wärmebehandlung zu brechen.

11. Verfahren nach Anspruch 10, wobei die Bruchzone (17d) durch Implantieren von Arten erhalten wird.

12. Verfahren nach einem der Ansprüche 1 bis 11, wobei die Versiegelungsfolie (16) ein Halbleitermaterial umfasst, vorteilhafterweise umfasst das Halbleitermaterial mindestens Elemente, ausgewählt aus: Silizium, Germanium, Silizium-Germanium-Legierung, Phosphorhart, Halbleiterarsenid III-V, Halbleiterphosphor III-V, oder ein Halbleiternitrit III-V, Siliziumkarbid.

13. Verfahren nach einem der Ansprüche 1 bis 11, wobei die Versiegelungsfolie (16) umfasst:
- ein metallisches Material, wobei das metallische Metall vorteilhafterweise mindestens Elemente umfasst, ausgewählt aus: Aluminium, Kupfer, Titan, Wolfram, Wolframsilizium, Gold;
- oder ein Isoliermaterial, wobei das Isoliermaterial vorteilhafterweise mindestens Elemente umfasst, ausgewählt aus: Siliziumdioxid, Siliziumnitrid;
- oder ein piezoelektrisches Material, wobei das piezoelektrische Material vorteilhafterweise mindestens Elemente umfasst, ausgewählt aus: Lithiumtantalat, Lithiumniobat, Aluminiumnitrid, Zinkoxid, Zink- und Bleitantalat.

14. Durchführung des Verfahrens nach einem der Ansprüche 1 bis 13 zur Herstellung eines elektromechanischen Mikrosystems.

15. Vorrichtung, die mit einer Vielzahl von Hohlräumen (11) versehen ist, die durch eine Vielzahl von Membranen (19) versiegelt sind, wobei die Vorrichtung umfasst:
a) eine Vielzahl von Hohlräumen (11), die im Bereich einer Vorderseite (10a) eines Trägersubstrats (10) oder im Bereich einer Versiegelungsseite einer Versiegelungsfolie münden, wobei die Hohlräume (11), die vorteilhaft matrixförmig angeordnet sind, eine Tiefe p, eine charakteristische Abmessung a, welche die größte Hohlraumabmessung ist, aufweisen und um einen Abstand b beabstandet sind;
b) eine Vielzahl von Membranen (19), die jeden der Hohlräume (11) versiegeln, die von der an der Vorderseite (10a) durch ihre Versiegelungsseite zusammengefügten Versiegelungsfolie (16) gebildet werden;
eine erste Kontur mit einer Breite L an der einen und/oder anderen der Vorderseite (10a) und der Versiegelungsseite, wobei die erste Kontur einen ersten Graben (21) umfasst, und so angeordnet ist, dass die Vielzahl von Hohlräumen (11) von der ersten Kontur umgeben ist;
wobei die Vorrichtung **dadurch gekennzeichnet ist, dass** die erste Kontur einen vorteilhaft im Wesentlichen konstanten Abstand G von der Vielzahl von Hohlräumen hat und zwischen einem Fünftel von b und fünf b, vorteilhafterweise zwischen einer Hälfte von b und zwei b, noch vorteilhafter zwischen 0,9xb und 1,1xb liegt.

## Claims

1. Method for sealing a plurality of cavities (11) using a plurality of membranes (19), the method comprising the following steps:
a) a step of forming a plurality of cavities (11) opening at a front face (10a) of a support substrate (10) or at a sealing face (16a) of a sealing film (16), the cavities (11), advantageously arranged in a matrix, have a depth p, a characteristic dimension a, and are spaced apart by a spacing b;
b) a step of forming a plurality of membranes (19), sealing each of the cavities (11), by transferring the sealing film (16) overlapping with the front face (10a), the transfer comprising assembly the sealing face (16a) with the front face (10a);
a step a1), executed before step b), of forming a first contour on one and/or the other of the front face (10a) and the sealing face (16a), the first contour comprising an advantageously continuous first trench (21), having a width L and a first depth p1, the formation of the first contour being executed such that after step b) the plurality of cavities (11) is circumscribed by the first contour,
the method being **characterised in that** said first contour is at an advantageously essentially constant distance G from the plurality of cavities between one-fifth of b and five b, advantageously between one-half of b and two b, more advantageously between 0.9xb and 1.1xb.

2. Method according to claim 1, wherein the width L is between one-fifth of a and five a, advantageously between one-half of a and two a, more advantageously between 0.9xa and 1.1xa.

3. Method according to claim 1 or 2, wherein the cavities (11) are of square, round, or polygonal shape and particularly of hexagonal shape.

4. Method according to one of claims 1 to 3, wherein the first contour is formed:
- on the front face, and step b) is followed by a step c) of partially removing the sealing film (16) so as to uncover the first contour, said partial removal retaining a section of the sealing film (16) circumscribed by the first contour;
- and/or on the sealing face, and the first depth p1 is less than the thickness of the sealing film;
- or on the sealing face, and the first depth p1 is greater than or equal to the thickness of the sealing film such that after step b), the first contour is exposed to the external environment.

5. Method according to one of claims 1 to 4, wherein step a1) also comprises the formation of at least a second contour, on one and/or the other of the front face (10a) and the sealing face (16a), which comprises a second trench (31) around the first trench (21), advantageously at all points, at an essentially constant distance from the first contour.

6. Method according to claim 5, wherein the first contour and the at least a second contour are linked by one or more interconnection channels (40), advantageously, the one or more interconnection channels (40) link two adjacent corners, respectively, of the first contour and the second contour.

7. Method according to one of claims 1 to 6, wherein the transfer step b) comprises a step b1) of bonding a donor substrate (17) with the support substrate (10), the donor substrate (17) being provided with the sealing film (16) resting on a handle substrate (17a), followed by a step b2) of removing the handle substrate (17a).

8. Method according to claim 7, wherein step b2) comprises etching by mechanical and/or chemical abrasion.

9. Method according to claim 8, wherein the donor substrate-(17) comprises an intermediate layer (17c) inserted between the handle substrate (17a) and the sealing film (16), the intermediate layer (17c) having an etching selectivity relative to the sealing film (16) and the handle substrate (17a).

10. Method according to claim 7, wherein the donor substrate (17) comprises an embrittlement zone (17d) delimiting the sealing film (16), and configured to break by applying mechanical stress and a heat treatment.

11. Method according to claim 10, wherein the embrittlement zone (17d) is obtained by species implantation.

12. Method according to one of claims 1 to 11, wherein the sealing film (16) comprises a semiconductor material, advantageously the semiconductor material comprises at least elements chosen from: silicon, germanium, silicon and germanium alloy, indium phosphide, a III-V semiconductor arsenide, a III-V semiconductor phosphide, or a III-V semiconductor nitride, silicon carbide.

13. Method according to one of claims 1 to 11, wherein the sealing film (16) comprises:
- a metallic material, advantageously the metallic material comprises at least elements chosen from: aluminium, copper, titanium, tungsten, tungsten silicide, gold;
- or an insulating material, advantageously the insulating material comprises at least elements chosen from: silicon dioxide, silicon nitride;
- or a piezoelectric material, advantageously the piezoelectric material comprises at least elements chosen from: lithium tantalate, lithium niobate, aluminium nitride, zinc oxide, zinc and lead tantalate.

14. Use of the method according to one of claims 1 to 13 for manufacturing a micro-electromechanical system.

15. Device provided with a plurality of cavities (11) sealed using a plurality of membranes (19), the device comprising:
a) a plurality of cavities (11) opening at a front face (10a) of a support substrate (10) or at a sealing face of a sealing film, the cavities (11), advantageously arranged in a matrix, have a depth p, a characteristic dimension a, and are spaced apart by a spacing b;
b) a plurality of membranes (19), sealing each of the cavities (11), formed by the sealing film (16) assembled with the front face (10a) using the sealing face thereof;
a first contour of a width L on one and/or the other of the front face (10a) and the sealing face, the first contour comprising a first trench (21), and is arranged such that the plurality of cavities (11) is circumscribed by the first contour,
the device being **characterised in that**
said first contour being at an advantageously essentially constant distance G from the plurality of cavities and between one-fifth of b and five b, advantageously between one-half of b and two b, more advantageously between 0.9xb and 1.1xb.
